(19) Europäisches Patentamt / European Patent Office / Office européen des brevets

(11) **EP 4 270 046 A1**

(12) **EUROPEAN PATENT APPLICATION**
published in accordance with Art. 153(4) EPC

(43) Date of publication:
**01.11.2023 Bulletin 2023/44**

(21) Application number: **22845965.7**

(22) Date of filing: **20.07.2022**

(51) International Patent Classification (IPC):
*G01S 7/03* (2006.01)          *H05K 9/00* (2006.01)
*G01S 13/931* (2020.01)

(52) Cooperative Patent Classification (CPC):
**G01S 7/03; H05K 9/00;** G01S 13/931

(86) International application number:
**PCT/JP2022/028279**

(87) International publication number:
**WO 2023/003032 (26.01.2023 Gazette 2023/04)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority:  **21.07.2021  JP 2021121072**

(71) Applicant: **NITTO DENKO CORPORATION**
**Ibaraki-shi**
**Osaka 567-8680 (JP)**

(72) Inventors:
• **UI Takehiro**
  **Ibaraki-shi, Osaka 567-8680 (JP)**
• **FUKE Kazuhiro**
  **Ibaraki-shi, Osaka 567-8680 (JP)**
• **MATSUZAKI Yuya**
  **Ibaraki-shi, Osaka 567-8680 (JP)**
• **AKIYAMA Kyohei**
  **Ibaraki-shi, Osaka 567-8680 (JP)**

(74) Representative: **Grünecker Patent- und Rechtsanwälte**
**PartG mbB**
**Leopoldstraße 4**
**80802 München (DE)**

(54) **ELECTROMAGNETIC WAVE SHIELD**

(57)    An electromagnetic shield 1a includes a plate-shaped base 5, a plurality of first projecting portions 11, and a contact portion 5f. The base 5 has a first surface 10 and a second surface 20. The first surface 10 is a surface configured to allow an electromagnetic wave to be incident on the first surface 10. The second surface 20 is distant from the first surface 10 and extends along the first surface 10. The plurality of first projecting portions 11 project from the first surface 10 in a direction away from the second surface 20. The electromagnetic shield 1a includes a dielectric. The electromagnetic shield 1a is capable of being attached to a component other than the electromagnetic shield 1a such that the component is in contact with the contact portion 5f and the first surface 10 faces the component. The electromagnetic shield 1a includes a second projecting portion 21a in a particular portion 10p. A distance from the contact portion 5f to the particular portion 10p in a direction parallel to the first surface 10 is equal to or shorter than a first distance d1 between the first projecting portion 11 closest to the contact portion 5f and the contact portion 5f.

FIG.3

## Description

TECHNICAL FIELD

The present invention relates to an electromagnetic shield.

BACKGROUND ART

Sensing systems using radio waves have been known. For example, collision avoidance systems including a radar using a radio wave with a given wavelength are under discussion in the automotive technical field. Such collision avoidance systems, for example, detect obstacles, measure the speed of nearby vehicles, measure a distance between a vehicle equipped with the system and its nearby vehicle, and then adjust the speed of the vehicle and a vehicle-to-vehicle distance. To allow a collision avoidance system to normally operate, it is important not to receive unnecessary radio waves, which make noise.

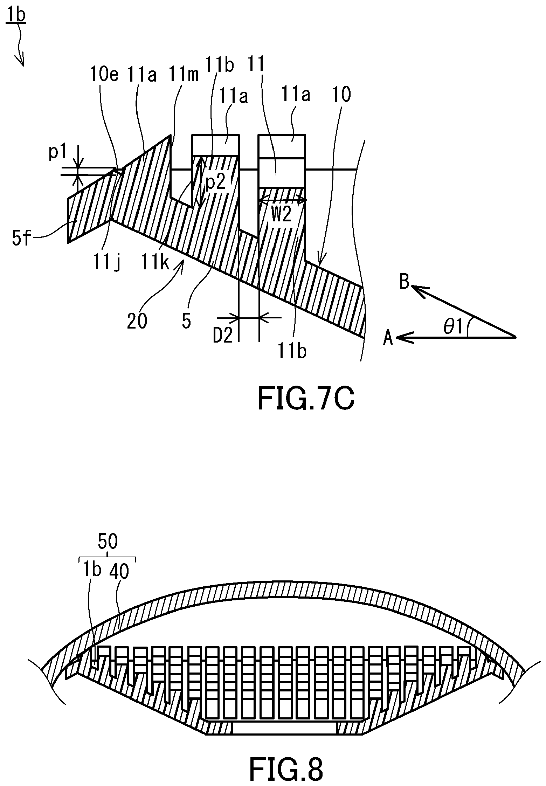

Patent Literature 1 describes a radar device attached to and supported by a rear bumper through an attaching member (refer to FIG. 8). The attaching member includes a box-shaped housing section, and the housing section includes a shield plate. The shield plate closes a path between a vehicle-widthwise outer side portion of the radar device and a backside of a rear bumper to block a transmission wave. The shield plate is provided as a misdetection prevention member to close a path of a tire arrival wave α, so that misdetection is prevented.

Patent Literature 2 describes an automotive radar module (refer to FIG. 7B). This automotive radar module reduces multipath effects by providing a shield, a mounting fixing device, or a bracket with one or more patterned surfaces.

CITATION LIST

Patent Literature

Patent Literature 1: JP 5696781 B1
Patent Literature 2: US 10,074,907 B2

SUMMARY OF INVENTION

Technical Problem

Using an electromagnetic shield for blocking electromagnetic waves is conceivable from the viewpoint of preventing reception of unnecessary radio waves. The electromagnetic shield is supposed to be attached to other components when used. However, the above patent literatures fail to give any particular discussion in terms of ease of attachment of the electromagnetic shields to other components.

In view of such circumstances, the present invention provides an electromagnetic shield that is advantageous in electromagnetic shielding and ease of attachment to other components.

Solution to Problem

The present invention provides an electromagnetic shield, including:

a plate-shaped base having a first surface and a second surface, the first surface being configured to allow an electromagnetic wave to be incident on the first surface, the second surface being distant from the first surface and extending along the first surface;
a plurality of first projecting portions projecting from the first surface in a direction away from the second surface; and
a contact portion configured to be in contact with a component other than the electromagnetic shield, wherein
the electromagnetic shield includes a dielectric,
the electromagnetic shield is capable of being attached to the component such that the component is in contact with the contact portion and the first surface faces the component, and
the electromagnetic shield satisfies at least one selected from the group consisting of the following requirements (I) and (II):

(I) the electromagnetic shield includes, in a particular portion, a second projecting portion projecting from the second surface in a direction away from the first surface, and a distance from the contact portion to the particular portion in a direction parallel to the first surface is equal to or shorter than a first distance between the first projecting portion closest to the contact portion and the contact portion, the particular portion being a portion including the contact portion and the first projecting portion closest to the contact portion; and

(II) the plurality of first projecting portions includes a proximal projecting portion and a distal projecting portion, a projection length of the proximal projecting portion is shorter than a projection length of the distal projecting portion, and the distal projecting portion is adjacent to the proximal projecting portion in a direction away from the contact portion.

Advantageous Effects of Invention

The above electromagnetic shield advantageous in electromagnetic shielding and ease of attachment to other components.

BRIEF DESCRIPTION OF DRAWINGS

FIG. 1 is a plan view showing an example of the electromagnetic shield according to the present invention.
FIG. 2 is a cross-sectional view showing the electromagnetic shield along a line II-II shown in FIG. 1.
FIG. 3 is a cross-sectional view showing a portion of the electromagnetic shield shown in FIG. 1.
FIG. 4 is a cross-sectional view showing a portion of an electromagnetic shield according to a reference example.
FIG. 5 is a cross-sectional view showing a portion of an electromagnetic shield according to another reference example.
FIG. 6 is a cross-sectional view showing the electromagnetic-shield-including article according to the present invention.
FIG. 7A is a plan view showing another example of the electromagnetic shield according to the present invention.
FIG. 7B is a cross-sectional view showing the electromagnetic shield along a line B-B shown in FIG. 7A.
FIG. 7C is a cross-sectional view showing a portion of the electromagnetic shield shown in FIG. 7A.
FIG. 8 is a cross-sectional view showing another example of the electromagnetic-shield-including article according to the present invention.
FIG. 9 is a cross-sectional view showing another example of the electromagnetic shield according to the present invention.
FIG. 10 is a cross-sectional view showing another example of the electromagnetic shield according to the present invention.
FIG. 11 is a cross-sectional view showing another example of the electromagnetic shield according to the present invention.

DESCRIPTION OF EMBODIMENTS

Hereinafter, embodiments of the present invention will be described with reference to the drawings. The present invention is not limited to the following embodiments.

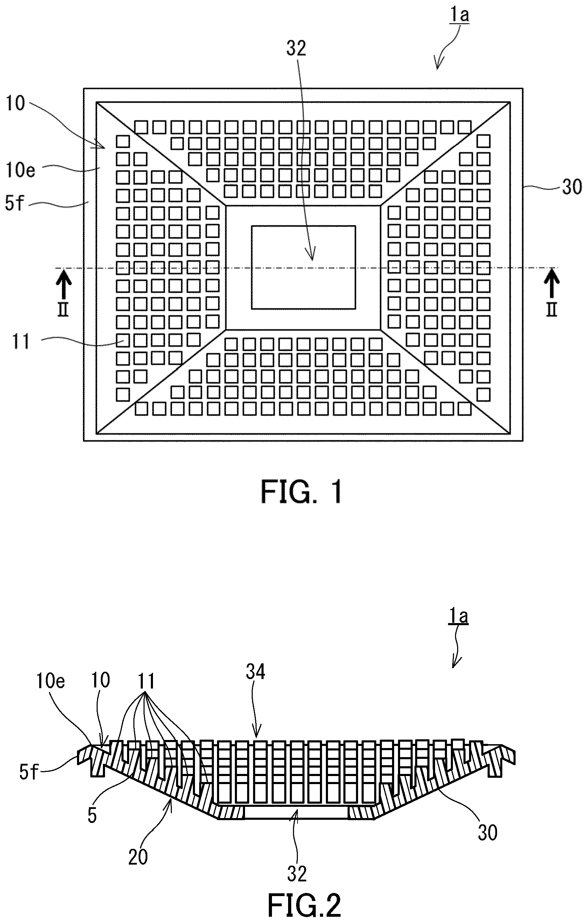

As shown in FIGS. 1 and 2, an electromagnetic shield 1a includes a plate-shaped base 5, a plurality of first projecting portions 11, and a contact portion 5f. The plate-shaped base 5 has a first surface 10 and a second surface 20. The first surface 10 is a surface configured to allow an electromagnetic wave to be incident on the first surface 10. The second surface 20 is distant from the first surface 10 and extends along the first surface 10. In other words, the first surface 10 and the second surface 20 face opposite directions. The plurality of first projecting portions 11 projects from the first surface 10 in a direction away from the second surface 20. The contact portion 5f is a portion configured to be in contact with a component other than the electromagnetic shield 1a. The electromagnetic shield 1a includes a dielectric. The electromagnetic shield 1a is capable of being attached to a component other than the electromagnetic shield 1a such that the component is in contact with the contact portion 5f and the first surface 10 faces the component.

As shown in FIG. 2, the plurality of first projecting portions 11 projects from the base 5. With such a configuration, the plurality of first projecting portions 11 is likely to be disposed in a desired state. Moreover, the electromagnetic shield 1a is likely to have a high mechanical strength.

A thickness of the base 5 is not limited to a particular value. The thickness of the base 5 is, for example, 0.5 mm to 3 mm. The thickness of the base 5 may be 0.7 mm or more, or 0.8 mm or more. The thickness of the base 5 may be 2.5 mm or less, or 2 mm or less.

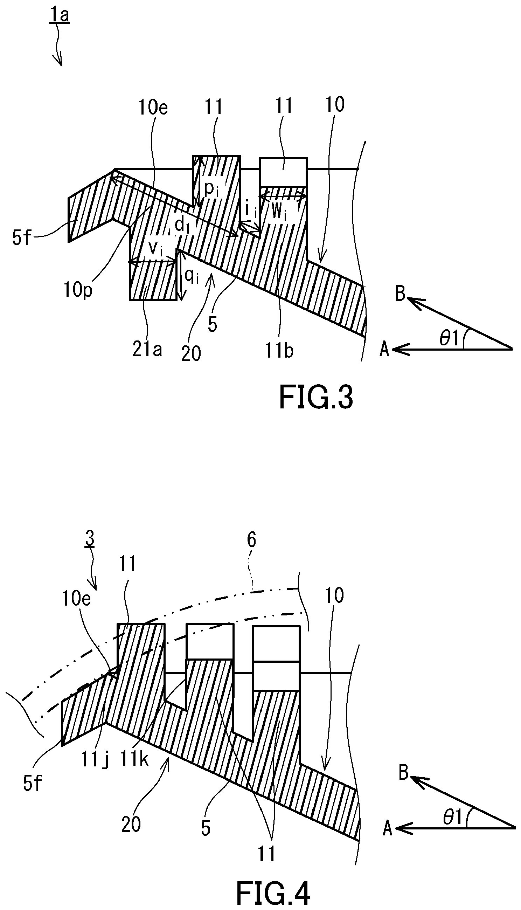

As shown in FIG. 3, for example, the electromagnetic shield 1a is disposed such that the base 5 forms a given acute angle θ1 with a horizontal plane and extends obliquely upward toward the contact portion 5f. In FIG. 3, an arrow A is horizontal, while an arrow B is parallel to the base 5. In the case of such disposition, the plurality of first projecting portions 11 projects, for example, upward in a direction perpendicular to the horizontal plane. Such a configuration makes it easy to manufacture the electromagnetic shield 1a by molding. In the case of such disposition, one or more of the first projecting portions 11 are positioned, for example, higher than an uppermost portion of the base 5.

As shown in FIG. 1, the contact portion 5f forms, for example, a flange. The contact portion 5f thus configured is likely to be used, for example, to attach the electromagnetic shield 1a to other components.

As shown in FIG. 3, the electromagnetic shield 1a includes, in a particular portion 10p, a second projecting portion 21a projecting from the second surface 20 in a direction away from the first surface 10. A distance from the contact portion 5f to the particular portion 10p in a direction parallel to the first surface 10 is equal to or shorter than a first distance $d_1$ between the first projecting portion 11 closest to the contact portion 5f and the contact portion 5f. In FIG. 3, the arrow A is horizontal. A projection length of the first projecting portion 11 and a projection length of the second projecting portion 21a are each determined, for example, as a length in a projecting direction, which is perpendicular to a horizontal plane, of each projecting portion. It should be noted that the particular portion 10p is a portion including the contact portion 5f and the first projecting portion 11 closest to the contact portion 5f.

The term "electromagnetic shield" herein refers to an article that can exhibit a function of attenuating the energy of an electromagnetic wave. The principle on which an electromagnetic shield attenuates the energy of an electromagnetic wave is not limited to a particular principle. The principle can be, for example, one using a phenomenon, such as reflection, transmission, absorption, diffraction, or interference, accompanying an interaction between an electromagnetic wave and an electromagnetic shield and a phenomenon, such as scattering or diffusion of the electromagnetic wave, caused by the above phenomenon. The energy of a given electromagnetic wave incident on the first surface 10 of the electromagnetic shield 1a is attenuated.

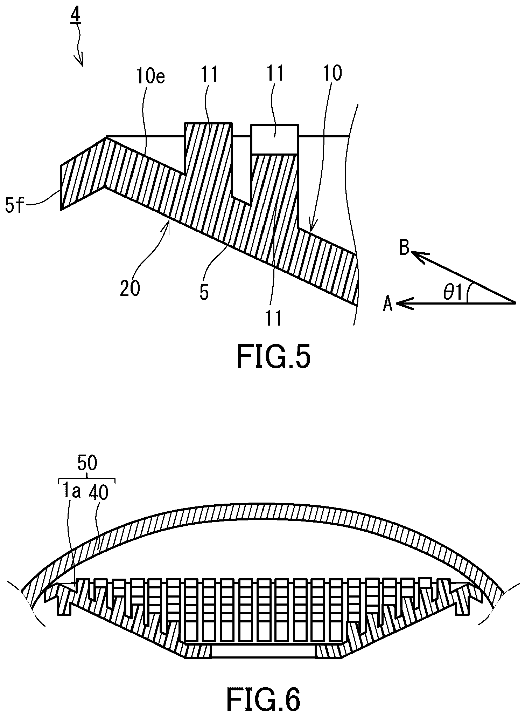

FIG. 4 shows an electromagnetic shield 3 according to a reference example. FIG. 5 shows an electromagnetic shield 4 according to another reference example. The electromagnetic shields 3 and 4 are configured in the same manner as the electromagnetic shield 1a unless otherwise described. The components of the electromagnetic shields 3 and 4 that are the same as or correspond to the components of the electromagnetic shield 1a are denoted by the same reference characters and detailed descriptions of such components are omitted.

As shown in FIG. 4, in the electromagnetic shield 3, the first projecting portions 11 have the same shape and the same dimensions, and a projection length of a portion 11j of the first projecting portion 11 closest to the contact portion 5f is equal to a projection length of a portion 11k of another first projecting portion 11 adjacent, in a direction away from the contact portion 5f, to the first projecting portion 11 closest to the contact portion 5f, the portion 11j being closest to the contact portion 5f than the other portion of the first projecting portion 11 closest to the contact portion 5f, the portion 11k being closest to the contact portion 5f than the other portion of the other first projecting portion 11. For example, in the case of attaching the electromagnetic shield 3 to a component 6, the first projecting portion 11 closest to the contact portion 5f may hinder attachment of the electromagnetic shield 3 to the component 6, making it difficult to firmly attach the electromagnetic shield 3 to the component 6.

It is therefore conceivable that, as shown in the electromagnetic shield 4 shown in FIG. 5, the first projecting portion 11 is omitted in a region 10e of the first surface 10, the region 10e being in contact with the contact portion 5f. It seems that if a ratio of the area of the region 10e of the first surface 10 in contact with the contact portion 5f to the area of the first surface 10 is not too large, the electromagnetic shielding performance of the electromagnetic shield 4 is rarely different from the electromagnetic shielding performance of an electromagnetic shield where the first projecting portion 11 is not omitted in the region 10e. In the case of omitting the first projecting portion 11 in the region 10e, the first projecting portions 11 do not hinder attachment of the electromagnetic shield 4 to the component 6, unlike in the electromagnetic shield 3. However, studies by the present inventors have newly revealed that lack of the projecting portion 11 in the region 10e gives a non-negligible effect on the electromagnetic shielding performance of an electromagnetic shield.

Since the electromagnetic shield 1a includes, as described above, the second projecting portion 21a in the particular portion 10p, the electromagnetic shield 1a can block an electromagnetic wave in a desired state, the electromagnetic wave being incident in the vicinity of the particular portion 10p. Therefore, the electromagnetic shield 1a is likely to have high electromagnetic shielding performance. Additionally, the first projecting portion 11 is less likely to hinder attachment of the electromagnetic shield 1a to other components. As just described, the electromagnetic shield 1a is advantageous in electromagnetic shielding and ease of attachment to other components.

The shapes of the electromagnetic shield 1a and the base 5 are not limited to particular shapes. As shown in FIGS. 1 and 2, at least one selected from the group consisting of the electromagnetic shield 1a and the base 5 is, for example, a ring-shaped body and has a polygonal or circular outer perimeter when the first surface 10 is viewed along an axis of the ring-shaped body. The contact portion 5f abuts on, for example, the outer perimeter. Such a configuration can block an electromagnetic wave incident on the first surface 10 through a space surrounded by the electromagnetic shield 1a.

As shown in FIGS. 1 and 2, an outer shape of at least one of the electromagnetic shield 1a and the base 5 is, for example, a truncated pyramidal shape. At least one of the electromagnetic shield 1a and the base 5 is, for example, a hollow body and has an opening in each of positions in the outer shape, the positions corresponding to an upper base and a lower base of a truncated pyramid. At least one of the electromagnetic shield 1a and the base 5 has, for example, a first opening 32 in a position corresponding to the upper base of a truncated pyramid and a second opening 34 in a position corresponding to the lower base thereof. The first surface 10 defines an inner peripheral surface of at least one of the hollow body being the electromagnetic shield 1a and the hollow body being the base 5. The second surface 20 defines an outer peripheral surface of at least one of the hollow body being the electromagnetic shield 1a and the hollow body being the base 5. With such a configuration, electromagnetic shielding by the electromagnetic shield 1a can be achieved in a larger space. Furthermore, the first opening 32 of the electromagnetic shield 1a can be used to dispose therein an antenna for transmission and reception of an electromagnetic wave. The outer shape of at least one of the electromagnetic shield 1a and the base 5 may be a truncated conical shape or a truncated elliptical conical shape. In this case, the electromagnetic shield 1a has an opening in each of positions in the outer shape, the positions corresponding to the upper base and the lower base of a truncated cone or a truncated elliptic cone.

The plurality of first projecting portions 11 projects, for example, in a direction perpendicular to the lower base of a truncated pyramid, a truncated cone, or a truncated elliptic cone being the outer shape of the electromagnetic shield 1a or the base 5. With such a configuration, the electromagnetic shield 1a is likely to have even higher electromagnetic shielding performance. Moreover, such a configuration is advantageous in manufacturing, for example, in that the configuration is so simple that an article made by injection molding can be removed from a mold without equipping the mold with a structure such as a slide core.

The first projecting portion 11 may have a draft angle toward a direction away from the base 5. A corner portion of the first projecting portion 11 may be formed of a curved surface having a given curvature radius. Such a configuration is desirable, for example, in manufacturing the electromagnetic shield 1a by injection molding from the viewpoint of removal of a molded article from a mold.

The electromagnetic shield 1a can be used, for example, as an electromagnetic shield for millimeter-wave radars, millimeter-wave radio communication, millimeter-wave sensing, or the like. A device including the electromagnetic shield 1a can be used, for example, in automobiles and wireless base stations. When the electromagnetic shield 1a is for millimeter-wave radars, the electromagnetic shield 1a can be included in a millimeter-wave radar using one frequency band selected from the group consisting of the 24 GHz band, the 60 GHz band, the 76 GHz band, and the 79 GHz band. The electromagnetic shield 1a is not just for blocking only an electromagnetic wave with a particular wavelength, and may block electromagnetic waves in a wide wavelength region. It is also possible to regard an electromagnetic wave with a particular wavelength $\lambda$ as a "shielding target" of the electromagnetic shield 1a. For example, in the case of the electromagnetic shield installed with a vehicle-mounted millimeter-wave radar configured to irradiate an object with an electromagnetic wave practically having frequencies of 76 to 77 GHz, i.e., having practical irradiation wavelengths of 3.89 to 3.94 mm, 3.92 mm which is the wavelength of the center frequency, 76.5 GHz, can be understood as the wavelength $\lambda$, namely, the shielding target of this electromagnetic shield. In the case where the electromagnetic shield is for vehicle-mounted millimeter-wave radars using an electromagnetic wave having frequencies of 77 to 81 GHz, i.e., using an electromagnetic wave having wavelengths of 3.70 to 3.89 mm, 3.79 mm, which is the wavelength of the center frequency, 79 GHz, can be understood as the wavelength $\lambda$, namely, the shielding target of this electromagnetic shield. In the case where the electromagnetic shield is for vehicle-mounted millimeter-wave radars using an electromagnetic wave having frequencies of 24.05 to 24.25 GHz, i.e., using an electromagnetic wave having wavelengths of 12.36 to 12.47 mm, 12.41 mm, which is the wavelength of the center frequency, 24.15 GHz, can be understood as the wavelength $\lambda$, namely, the shielding target of this electromagnetic shield. In the case where the electromagnetic shield is for vehicle-mounted millimeter-wave radars using an electromagnetic wave having frequencies of 60.0 to 60.1 GHz, i.e., using an electromagnetic wave having wavelengths of 4.99 to 5.00 mm, 4.99 mm, which is the wavelength of the center frequency, 60.05 GHz, can be understood as the wavelength $\lambda$, namely, the shielding target of this electromagnetic shield. In the case where the electromagnetic shield is for millimeter-wave radio communication using an electromagnetic wave having frequencies of 27 to 29.5 GHz, i.e., using an electromagnetic wave having wavelengths of 10.16 to 11.10 mm, 10.61 mm, which is the wavelength of the center frequency, 28.25 GHz, can be understood as the wavelength $\lambda$, namely, the shielding target of this electromagnetic shield. In the case where the electromagnetic shield is, for example, sold with a label saying that its supporting frequencies are 70 to 90 GHz, i.e., its supporting wavelengths are 3.33 to 4.28 mm, 3.75 mm, which is the wavelength of the center frequency, 80 GHz, can be understood as the wavelength $\lambda$, namely, the shielding target of this electromagnetic shield.

A projection length pi of the first projecting portion 11 is not limited to a particular value. The electromagnetic shield 1a is capable of blocking, for example, an electromagnetic wave with the wavelength $\lambda$. When the projection length pi is compared with the wavelength $\lambda$, namely, the shielding target of the electromagnetic shield, the projection length pi is, for example, $0.25\lambda$ or more, and may be $5.1\lambda$ or less, $3.5\lambda$ or less, or $3.0\lambda$ or less. At least one of the projection lengths pi of the first projecting portions desirably satisfies a requirement $0.25\lambda \leq p_i \leq 1.3\lambda$. In this case, the electromagnetic shield 1a is likely to have even higher electromagnetic shielding performance. The projection length pi is a projection length of a portion of the first projecting portion 11, the portion being closest to the contact portion 5f. The projection length pi may be $0.30\lambda$ or more, $0.35\lambda$ or more, $0.40\lambda$ or more, $0.45\lambda$ or more, $0.50\lambda$ or more, $0.51\lambda$ or more, or $0.77\lambda$ or more. The projection length pi may be $1.2\lambda$ or less, $1.1\lambda$ or less, $1.0\lambda$ or less, or $0.9\lambda$ or less.

Fifty percent or more of the first projecting portions 11 on a number basis satisfy, for example, the requirement $0.25\lambda \leq p_i \leq 1.3\lambda$. Sixty percent or more of the first projecting portions 11 on a number basis may satisfy the requirement $0.25\lambda \leq p_i \leq 1.3\lambda$. Seventy percent or more of the first projecting portions 11 on a number basis may satisfy the requirement $0.25\lambda \leq p_i \leq 1.3\lambda$. Eighty percent or more of the first projecting portions 11 on a number basis may satisfy the requirement $0.25\lambda \leq p_i \leq 1.3\lambda$. Ninety percent or more of the first projecting portions 11 on a number basis may satisfy the requirement $0.25\lambda \leq p_i \leq 1.3\lambda$. All first projecting portions 11 may satisfy the requirement $0.25\lambda \leq p_i \leq 1.3\lambda$.

A width $w_i$ of the first projecting portion 11 is not limited to a particular value. When the width $w_i$ is compared with the wavelength $\lambda$, namely, the shielding target of the electromagnetic shield, the width $w_i$ is, for example, $0.12\lambda$ or more, and may be $5.0\lambda$ or less, $4.0\lambda$ or less, or $3.0\lambda$ or less. At least one of the widths $w_i$ of the first projecting portions 11 desirably satisfies a requirement $0.51\lambda \leq w_i \leq 1.6\lambda$. In this case, the electromagnetic shield 1a is likely to have even higher electromagnetic shielding performance. The width $w_i$ is a dimension of an outline of the first projecting portion 11 viewed in a direction opposite to the projecting direction of the first projecting portion 11, the dimension being measured in a direction in which a distance between a pair of parallel straight lines sandwiching and in contact with the outline is shortest. The width $w_i$ may be $0.55\lambda$ or more, $0.60\lambda$ or more, $0.65\lambda$ or more, $0.70\lambda$ or more, or $0.75\lambda$ or more. The width $w_i$ may be $1.5\lambda$ or less, $1.4\lambda$ or less, $1.3\lambda$ or less, $1.2\lambda$ or less, $1.1\lambda$ or less, or $1.0\lambda$ or less.

Fifty percent or more of the first projecting portions 11 on a number basis satisfy, for example, the requirement $0.51\lambda \leq w_i \leq 1.6\lambda$. Sixty percent or more of the first projecting portions 11 on a number basis may satisfy the requirement $0.51\lambda \leq w_i \leq 1.6\lambda$. Seventy percent or more of the first projecting portions 11 on a number basis may satisfy the requirement $0.51\lambda \leq w_i \leq 1.6\lambda$. Eighty percent or more of the first projecting portions 11 on a number basis may satisfy the requirement $0.51\lambda \leq w_i \leq 1.6\lambda$. Ninety percent or more of the first projecting portions 11 on a number basis may satisfy the requirement $0.51\lambda \leq w_i \leq 1.6\lambda$. All first projecting portions 11 may satisfy the requirement $0.51\lambda \leq w_i \leq 1.6\lambda$.

An interval $i_i$ between the first projecting portions 11 adjacent each other is not limited to a particular value. When the interval $i_i$ is compared with the wavelength $\lambda$, namely, the shielding target of the electromagnetic shield, the interval $i_i$ is, for example, $5.1\lambda$ or less, and may be $3.10\lambda$ or less, or $2.04\lambda$ or less. The interval $i_i$ is, for example, $0.25\lambda$ or more, and may be $0.5\lambda$ or more, or $1.0\lambda$ or more. The interval $i_i$ desirably satisfies, for example, a requirement $0.51\lambda \leq i_i \leq 1.6\lambda$. In this case, the electromagnetic shield 1a is likely to have even higher electromagnetic shielding performance. The interval $i_i$ is the shortest distance between the first projecting portions 11 in the direction parallel to the first surface 10. The interval $i_i$ may be $0.55\lambda$ or more, $0.60\lambda$ or more, $0.65\lambda$ or more, $0.70\lambda$ or more, or $0.75\lambda$ or more. The interval $i_i$ may be $1.5\lambda$ or less, $1.4\lambda$ or less, or $1.3\lambda$ or less.

The shape of the first projecting portion 11 is not limited to a particular shape. The first projecting portion 11 has a shape of, for example, at least one selected from the group consisting of a circle, a triangle, a quadrilateral, and a polygon having five or more corners when viewed in plan. With such a configuration, the electromagnetic shield 1a is likely to have even higher electromagnetic shielding performance. As shown in FIG. 1, in the electromagnetic shield 1a, the first projecting portion 11 is square in plan view.

The first projecting portion 11 is formed in the shape of, for example, at least one selected from the group consisting of a cylinder, a prism, a cone, a pyramid, a truncated cone, and a truncated pyramid. The prism may be a quadrangular prism, a triangular prism, or another polygonal prism. The first projecting portion 11 may be formed in the shape of a strip. In this case, the plurality of first projecting portions 11 may include a plurality of projecting strips disposed parallel to each other. In this case, each projecting strip may extend linearly, in a wavelike manner, or in a zig-zag manner.

Arrangement of the plurality of first projecting portions 11 is not limited to particular arrangement. Arrangement of the plurality of first projecting portions 11 is, for example, at least one selected from the group consisting of arrangement at lattice points, arrangement on parallel lines, and random arrangement in plan view. Because of this, the electromagnetic shield 1a is likely to exhibit desired shielding performance over a wide area thereof when an electromagnetic wave with a wavelength $\lambda$ is incident on the electromagnetic shield 1a. Lattice points are points forming a plane lattice. A plane lattice is an array of points on a plane, the array being unchanged by parallel displacement in two independent directions over a constant distance each. According to the arrangement at lattice points, the plurality of first projecting portions 11 is arranged such that particular positions corresponding to the first projecting portions 11 form a plane lattice. According to the arrangement on parallel lines, the plurality of first projecting portions 11 is arranged such that particular linear portions corresponding to the first projecting portions 11 form parallel lines. According to the random arrangement, particular positions or linear portions corresponding to the first projecting portions 11 are arranged in random. As shown in FIG. 1a, in the electromagnetic shield 1a, arrangement of the first projecting portions 11 is, for example, arrangement at lattice points of a square lattice in plan view. Arrangement of the first projecting portions 11 may be arrangement at lattice points of a rectangular lattice or arrangement at lattice points of a parallelogram lattice in plan view.

As shown in FIG. 3, the region 10e of the first surface 10 in contact with the contact portion 5f is flat in the electromagnetic shield 1a. In other words, in the electromagnetic shield 1a, no projecting portion being an equivalent of the first projecting portion 11 is provided in the region 10e. In the electromagnetic shield 1a, the second surface 20 includes the second projecting portion 21a in a position corresponding to the region 10e. The second projecting portion 21a projects, for example, from the second surface 20 in a direction away from the first projecting portion 11.

Since the region 10e of the first surface 10 is flat in the electromagnetic shield 1a, it is easy to attach an electromagnetic shield 1c to other components. Moreover, since the second projecting portion 21a can scatter a radio wave incident in the vicinity of the region 10e of the first surface 10, the electromagnetic shield 1a is likely to have high radio shielding performance.

A projection length qi of the second projecting portion 21a is not limited to a particular value. When the projection length $q_i$ is compared with the wavelength $\lambda$, namely, the shielding target of the electromagnetic shield 1a, the projection length qi is, for example, $0.25\lambda$ to $5.1\lambda$. The projection length qi may be $0.5\lambda$ or more, or $0.8\lambda$ or more. The projection length qi may be $3.5\lambda$ or less, or $1.5\lambda$ or less. The projection length qi may be $0.25\lambda$ or less and may be $5.1\lambda$ or more. The projection length $q_i$ desirably satisfies a requirement $0.25\lambda \leq q_i \leq 1.3\lambda$. In this case, the electromagnetic shield 1a is likely to have even higher electromagnetic shielding performance. The projection length qi is a projection length of a portion of the second projecting portion 11, the portion being farthest from the contact portion 5f. The projection length qi may be $0.30\lambda$ or more, $0.35\lambda$ or more, $0.40\lambda$ or more, $0.45\lambda$ or more, $0.50\lambda$ or more, $0.51\lambda$ or more, or $0.77\lambda$ or more. The projection length qi may be $1.2\lambda$ or less, $1.1\lambda$ or less, $1.0\lambda$ or less, or $0.9\lambda$ or less.

A width $v_i$ of the second projecting portion 21a is not limited to a particular value. When the width $v_i$ is compared with the wavelength $\lambda$, namely, the shielding target of the electromagnetic shield 1a, the width $v_i$ is, for example, $0.3\lambda$ to $5.0\lambda$. The width $v_i$ may be $0.4\lambda$ or more, or $0.5\lambda$ or more. The width $v_i$ may be $4.0\lambda$ or less, or $3.0\lambda$ or less. The width $v_i$ may be $0.3\lambda$ or less and may be $5.0\lambda$ or more. The width $v_i$ desirably satisfies a requirement $0.51\lambda \leq v_i \leq 1.6\lambda$. The width $v_i$ is a dimension, for example, of an outline of the second projecting portion 21a viewed in a direction opposite to a projecting direction of the second projecting portion 21a, the dimension being measured in a direction in which a distance between a pair of parallel straight lines sandwiching and in contact with the outline is shortest. The width $v_i$ may be $0.55\lambda$ or more, $0.60\lambda$ or more, $0.65\lambda$ or more, $0.70\lambda$ or more, or $0.75\lambda$ or more. The width $v_i$ may be $1.5\lambda$ or less, $1.4\lambda$ or less, $1.3\lambda$ or less, $1.2\lambda$ or less, $1.1\lambda$ or less, or $1.0\lambda$ or less.

An imaginary part $\varepsilon''$ of a relative permittivity of the dielectric included in the electromagnetic shield 1a is not limited to a particular value. For example, the imaginary part $\varepsilon''$ of the relative permittivity of the dielectric at at least one frequency $f_g$ in a range of 10 GHz to 300 GHz is 0.1 or less. It appears that the imaginary part $\varepsilon''$ of the dielectric is desirably large in the case of attenuating an electromagnetic wave using a dielectric loss. However, even if the imaginary part $\varepsilon''$ of the relative permittivity of the dielectric is as small as 0.1 or less, the electromagnetic shielding performance of the electromagnetic shield 1a is likely to be increased by adjusting a phenomenon caused by an interaction between the electromagnetic shield 1a and an electromagnetic wave. The imaginary part $\varepsilon''$ may be 0.07 or less, 0.05 or less, or 0.01 or less.

A real part $\varepsilon'$ of the relative permittivity of the dielectric included in the electromagnetic shield 1a is not limited to a particular value. For example, the real part $\varepsilon'$ of the relative permittivity of the dielectric at the frequency $f_g$ is 2.0 to 4.0. Even in this case, the electromagnetic shielding performance of the electromagnetic shield 1a is likely to be increased by adjusting a phenomenon caused by an interaction between the electromagnetic shield 1a and an electromagnetic wave. The real part $\varepsilon'$ may be 2.1 or more and 3.5 or less, or 2.2 or more and 3.0 or less. The real part $\varepsilon'$ may be 3.8 or less, 3.6 or less, 3.4 or less, 3.2 or less, 3.0 or less, 2.8 or less, 2.6 or less, or 2.4 or less.

The material of the dielectric included in the electromagnetic shield 1a is not limited to a particular one. The dielectric is made of, for example, a resin. The resin is, for example, a thermoplastic resin. Examples of the resin include polyethylene, polypropylene, polyvinyl alcohol, polyethylene terephthalate, polybutylene terephthalate, ethylene-vinyl acetate copolymer, polystyrene, acrylonitrile styrene, acrylonitrile butadiene-styrene copolymer, ASA resin, AES resin, acrylic resins such as PMMA, MS resin, MBS resin, cycloolefin resin, polyacetal resin, polyamide resin, polyester resin, polycarbonate resin, polyurethane resin, liquid crystal polymer, EPDM, PPS, PEEK, PPE, polysulfone-based resin, polyimide-based resin, fluorine resin, thermoplastic elastomers such as an olefin-based thermoplastic elastomer (TPO), and acrylic elastomers. The resin may be a thermosetting resin. The thermosetting resin is, for example, an epoxy resin, an acrylic resin, or a silicone resin. The dielectric may include only one resin or two or more resins.

The electromagnetic shield 1a may include, for example, a filler. The filler may be a colorant such as carbon black, an inorganic reinforcement such as talc, glass fibers, or a mineral, or a softener. The electromagnetic shield 1a may include an additive such as a flame retardant or a plasticizer. The electromagnetic shield 1a may be free of a filler. In this case, the cost of manufacturing the electromagnetic shield 1a is likely to be low.

The electromagnetic shield 1a is, for example, free of an electrically conductive portion. For blocking an electromagnetic wave, for example, an electrically conductive portion such as a metal film may be used to reflect an electromagnetic wave. However, the electromagnetic shield 1a can block an electromagnetic wave without an electrically conductive portion. The electromagnetic shield 1a may consist of the dielectric. The electromagnetic shield 1a may include an electrically conductive portion.

The electromagnetic shield 1a is, for example, a resin molded article. In this case, the cost of manufacturing the electromagnetic shield 1a is likely to be low.

In the case where the electromagnetic shield 1a is a resin molded article, the method for molding the electromagnetic shield 1a is not limited to a particular method. The electromagnetic shield 1a can be manufactured by injection molding, press molding, blow molding, or vacuum molding. The electromagnetic shield 1a may be manufactured by cutting or 3D printing.

An application of the electromagnetic shield 1a is not limited to a particular application. As shown in FIG. 1, for example, a radar cover 30 including the electromagnetic shield 1a can be provided. A component that includes the electromagnetic shield 1a and that is other than a radar cover may be provided.

As shown in FIGS. 1 and 2, the radar cover 30 is, for example, in the shape of a hollow truncated pyramid, and has the first opening 32 and the second opening 34. Each of the first opening 32 and the second opening 34 is, for example, rectangular. The second opening 34 is bigger than the first opening 32. A portion, such as an antenna of a radar (not illustrated), of a radar is disposed in the first opening 32. An internal surface of the radar cover 30 is formed of the first surface 10 of the electromagnetic shield 1a, and the plurality of first projecting portions 11 is provided on the internal surface. On the other hand, an external surface of the radar cover 30 is formed of the second surface 20 of the electromagnetic shield 1a.

An unnecessary radio wave incident on the internal surface of the radar cover 30 is blocked by the electromagnetic shield 1a. Reception of an unnecessary radio wave by a radar can be prevented thereby.

As shown in FIGS. 1 and 2, for example, the plurality of first projecting portions 11 is arranged on the almost entire first surface 10 forming the internal surface of the radar cover 30. An embodiment of the projecting portion 11 on the first surface 10 may be adjusted, if necessary. For example, the embodiment of the first projecting portion 11 can be adjusted so that traveling of a radio wave transmitted and received by a radar will not be hindered. For example, the projection length of the first projecting portion 11 in one part of the first surface 10 can be adjusted to a length different from the projection length of the first projecting portion 11 in another part of the first surface 10. In this case, for example, at least one of the following adjustments can be made: (i) adjusting a projection length of a first side portion of the first projecting portion 11 to be shorter than that of a second side portion of the same first projecting portion 11, the first side portion being closest to a radar than other side portions of the first projecting portion 11, the second side portion being opposite to the first side portion; and (ii) adjusting a projection length of a first side portion of one first projecting portion 11 to be shorter than a projection length of a side portion of another first projecting portion 11 adjacent to the one first projecting portion 11 in a direction away from a radar, the first side portion being closest to the radar, the side portion being closest to the radar. Alternatively, in a part of the first surface 10, the first projecting portion 11 may be omitted to make the first surface 10 flat. For example, a projecting portion is provided in a part of the second surface 20, the part corresponding to the above part, where such adjustment of the projection length of the first projecting portion 11 or such omission of the first projecting portion 11 is made, of the first surface 10. Consequently, the radar cover 30 is less likely to hinder traveling of a radio wave transmitted and received by a radar and can transmit an attenuated, unnecessary radio wave.

For example, in the radar cover 30, the above adjustment of the projection length of the first projecting portion 11 may be made in a part of the first surface 10, the part being in contact with the first opening 32. For example, the adjustment of the projection length may be made for at least one of the first projecting portions 11 lying in a row in a position closest to a radar in a particular direction. Additionally, the adjustment of the projection length may be made for another first projecting portion 11 adjacent, in a direction away from the radar, to the at least one of the first projecting portions 11 lying in a row in the position closest to the radar in the particular direction. In this case, the adjustment of the projection length of the first projecting portion 11 may be made for half or less of the first projecting portions 11 abutting on the first opening 32 on the first surface 10. This makes it possible to reduce the number of projecting portions provided on the second surface 20. A foreign matter such as dirt or water may be adhered to the second surface 20 being the external surface of the radar cover 30. Such a foreign matter adhered to the projecting portion provided on the second surface 20 is likely to decrease the ability to attenuate an unnecessary radio wave. Therefore, fewer projecting portions provided on the second surface 20 is advantageous in maintaining the ability to attenuate an unnecessary radio wave.

For example, in the radar cover 30, the above omission of the first projecting portion 11 may be made in a part of the first surface 10, the part being in contact with the first opening 32. For example, the first projecting portion 11 may be omitted in a part having an area large enough to dispose the first projecting portion 11 therein and being in a position closest to a radar in a particular direction. Additionally, the first projecting portion 11 may be omitted also in another part having an area large enough to dispose the first projecting portion 11 therein and being adjacent, in a direction away from the radar, to the above part having an area large enough to dispose the first projecting portion 11 therein and being in the position closest to the radar in the particular direction. In this case, the number of the first projecting portions 11 abutting on the first opening 32 on the first surface 10 is, for example, greater than the number of projecting portions provided on the second surface 20 and corresponding to the first projecting portions 11 omitted in a part of the first surface 10, the part being in contact with the first opening 32. This makes it possible to reduce the number of projecting portions provided on the second surface 20. Such a foreign matter adhered to the projecting portion provided on the second surface 20 is likely to decrease the ability to attenuate an unnecessary radio wave. Therefore, fewer projecting portions provided on the second surface 20 is advantageous in maintaining the ability to attenuate an unnecessary radio wave.

As shown in FIG. 6, an article 50 including the electromagnetic shield 1a can be provided. The article 50 includes the electromagnetic shield 1a and a component 40. The electromagnetic shield 1a is attached to the component 40 such that the component 40 faces the first surface 10 of the electromagnetic shield 1a. The electromagnetic shield 1a is attached to the electromagnetic shield 1a, for example, by joining such as welding or adhesion. The welding may be thermal welding or ultrasonic welding. The adhesion can be achieved, for example, using an adhesive, a pressure-sensitive adhesive, or a pressure-sensitive adhesive tape.

The component 40 is not limited to a particular component. The component 40 is, for example, a resin molded article. In this case, it is easy to weld the electromagnetic shield 1a to the component 40. The component 40 is, for example, a bumper of an automobile.

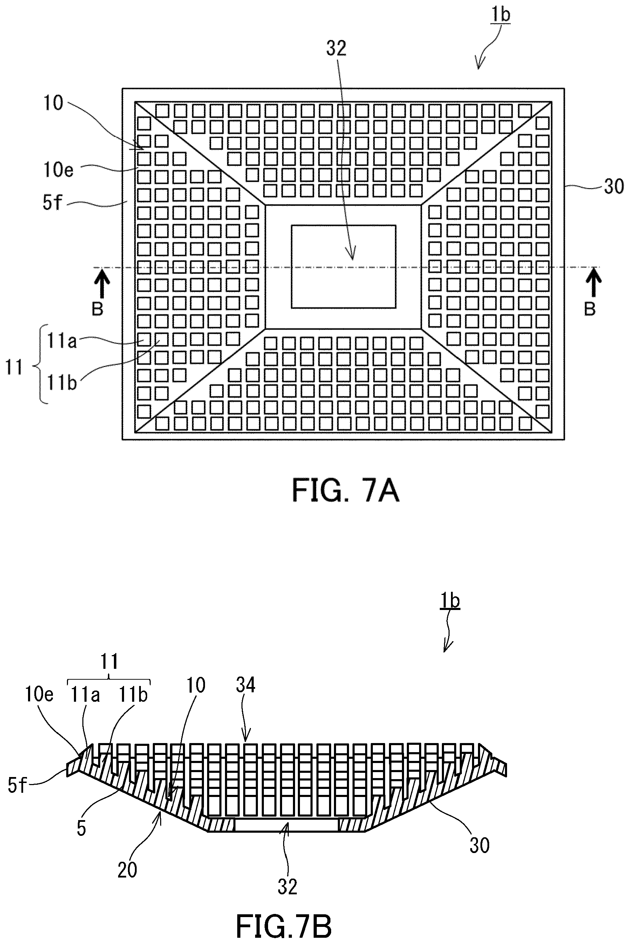

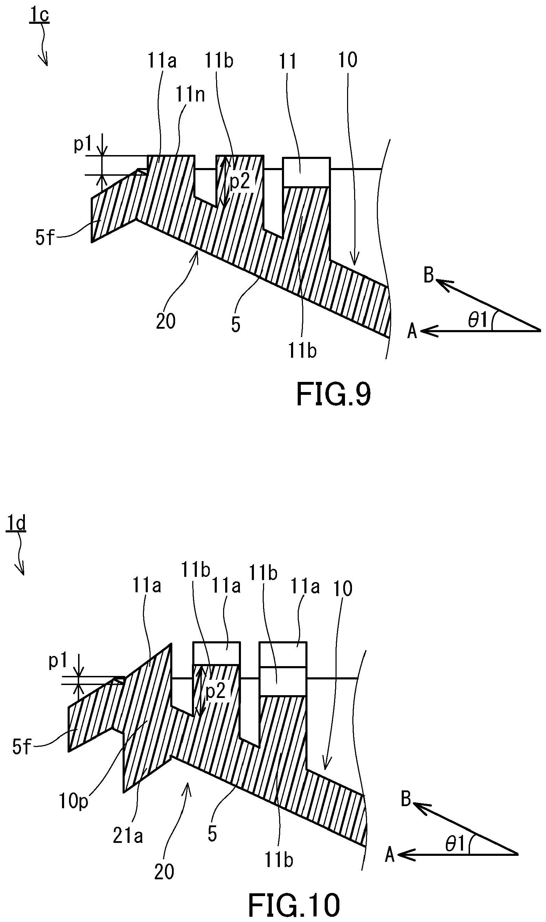

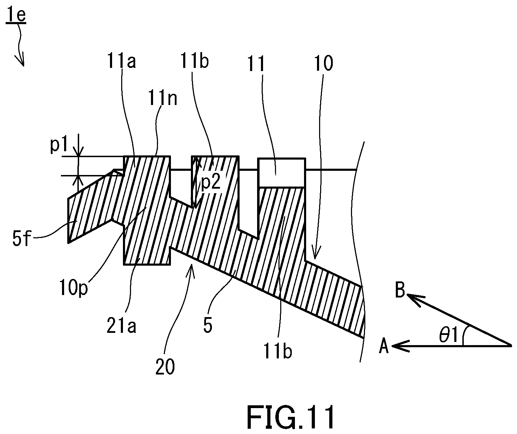

The electromagnetic shield 1a can be modified in various respects. For example, the electromagnetic shield 1a may be modified to an electromagnetic shield 1b shown in FIGS. 7A, 7B, and 7C, an electromagnetic shield 1c shown in FIG. 9, an electromagnetic shield 1d shown in FIG. 10, or an electromagnetic shield 1e shown in FIG. 11. The electromagnetic shields 1b, 1c, 1d, and 1e are configured in the same manner as the electromagnetic shield 1a unless otherwise described. The components of the electromagnetic shields 1b, 1c, 1d, and 1e that are the same as or correspond to the components of the electromagnetic shield 1a are denoted by the same reference characters, and detailed descriptions of such components are omitted. The description given for the electromagnetic shield 1a applies to the electromagnetic shields 1b, 1c, 1d, and 1e, unless there is technical inconsistency.

As shown in FIGS. 7A, 7B, and 7C, in the electromagnetic shield 1b, the plurality of first projecting portions 11 includes a proximal projecting portion 11a and a distal projecting portion 11b. As shown in FIG. 7C, a projection length p1 of the proximal projecting portion 11a is shorter than a projection length p2 of the distal projecting portion 11b. Because of this, the proximal projecting portion 11a is less likely to hinder attachment of the electromagnetic shield 1b to other components. As just described, the electromagnetic shield 1b is advantageous in electromagnetic shielding and ease of attachment to other components. The projection length p1 of the proximal projecting portion 11a and the projection length p2 of the distal projecting portion 11b are each a projection length of a portion of each projecting portion, the portion being closest to the contact portion 5f.

In the electromagnetic shield 1b, as long as the projection length p1 is shorter than the projection length p2, a ratio p1/p2 of the projection length p1 to the projection length p2 is not limited to a particular value. The ratio p1/p2 is, for example, 0 to 0.9. The ratio p1/p2 may be 0, 0.01 or more, 0.05 or more, or 0.1 or more. The ratio p1/p2 may be 0.8 or less, 0.7 or less, or 0.6 or less.

The shape of the proximal projecting portion 11a is not limited to a particular shape as long as the projection length p1 is shorter than the projection length p2. As shown in FIG. 7C, an innermost portion 11m of the proximal projecting portion 11a projects beyond an outermost portion 11j thereof in a projecting direction of the proximal projecting portion 11a. With such a configuration, the electromagnetic shield 1b is likely to have high electromagnetic shielding performance. A head of the proximal projecting portion 11a is, for example, tapered.

As shown in FIG. 7A, for example, in the electromagnetic shield 1b, the first projecting portions 11 are disposed in a row from an inner side of the electromagnetic shield 1b toward the region 10e of the first surface 10 in contact with the contact portion 5f. For example, only the first projecting portion 11 positioned outermost in the row serves as the proximal projecting portion 11a. However, in the case where the first projecting portion 11 positioned, in the row, closer to the inner side than the outermost first projecting portion 11 may hinder attachment of the electromagnetic shield 1b to other components, that first projecting portion 11 may also be configured as the proximal projecting portion 11a.

As shown in FIG. 8, the article 50 including the electromagnetic shield 1b can be provided. The article 50 includes the electromagnetic shield 1b and the component 40. The electromagnetic shield 1b is attached to the component 40 such that the component 40 faces the first surface 10 of the electromagnetic shield 1b. The electromagnetic shield 1b is attached to the electromagnetic shield 1b, for example, by joining such as welding or adhesion. The welding may be thermal welding or ultrasonic welding. The adhesion can be achieved, for example, using an adhesive, a pressure-sensitive adhesive, or a pressure-sensitive adhesive tape.

The component 40 is not limited to a particular component. The component 40 is, for example, a resin molded article. In this case, it is easy to weld the electromagnetic shield 1b to the component 40. The component 40 is, for example, a bumper of an automobile.

The electromagnetic shield 1c as shown in FIG. 9 is configured in the same manner as the electromagnetic shield 1b unless otherwise described. In the electromagnetic shield 1c, the proximal projecting portion 11a has an end face 11n. The end face 11n extends in a direction perpendicular to the projecting direction of the proximal projecting portion 11a. The proximal projecting portion 11a thus configured is even less likely to hinder attachment of the electromagnetic shield 1c to other components. When the electromagnetic shield 1c is disposed such that the projecting direction of the proximal projecting portion 11a is perpendicular to a horizontal plane, the end face 11n extends, for example, horizontally.

As shown in FIGS. 10 and 11, each of the electromagnetic shields 1d and 1e includes the second projecting portion 21a in the particular portion 10p. The second projecting portion 21a projects, for example, from the second surface 20 at a position corresponding to the proximal projecting portion 11a. With such a configuration, the second projecting portion 21a can block an electromagnetic wave incident in the vicinity of the region 10e of the first surface 10, and the electromagnetic shields 1d and 1e are likely to have high radio attenuation performance.

In the electromagnetic shields 1a, 1b, 1c, 1d, and 1e, an interaction occurring between the electromagnetic shield and an electromagnetic wave due to blocking of the electromagnetic wave is not limited to a particular interaction. Each of the electromagnetic shields 1a, 1b, 1c, 1d, and 1e, for example, transmits at least a portion of a radio wave incident on the first surface 11 and allows a scattered radio wave to emerge from the second surface 12. In other words, each of the electromagnetic shields 1a, 1b, 1c, 1d, and 1e can function as a radio-wave transmitting-scattering body. Electromagnetic shielding can therefore be achieved with a simple configuration.

Each of the electromagnetic shields 1a, 1b, 1c, 1d, and 1e has a scattering ratio of, for example, 0.1% or more. The term "scattering ratio" refers to a ratio of an intensity of a particular transmitted-scattered wave to an intensity of a straight transmitted wave emerging from the second surface 20, the intensities being measured when a radio wave is perpendicularly incident on the first surface 10. The scattering ratio is determined, for example, by the following equation (1). In the equation (1), "Intensity of transmitted-scattered wave" is, for example, the sum of intensities measured for a transmitted-scattered wave at scattering angles of 15°, 30°, 45°, 60°, and 75°. The term "scattering angle" refers to an angle between an emergent direction of a straight transmitted wave and an emergent direction of a transmitted-scattered wave.

$$\text{Scattering ratio} = \text{Intensity of transmitted-scattered wave/Intensity of straight transmitted wave} \qquad \text{Equation (1)}$$

The intensity of the transmitted-scattered wave and the intensity of the straight transmitted wave can be determined with reference to Japanese Industrial Standards (JIS) R 1679: 2007, for example, by allowing a radio wave to be perpendicularly incident on the first surface 10 and measuring a transmission loss in a straight direction and a transmission loss at a given scattering angle. Each transmission loss is expressed by the following equation (2). In the equation (2), Pi is a received electric power, and $P_0$ is a transmitted electric power. $|P_i/P_0|$ corresponds to the intensity of a transmitted wave. "Log" represents a common logarithm.

$$\text{Transmission loss} = |10\text{Log}(P_i/P_0)| \qquad \text{Equation (2)}$$

The scattering ratio of each of the electromagnetic shields 1a, 1b, 1c, 1d, and 1e may be 1% or more, 5% or more, 10% or more, 20% or more, 50% or more, 100% or more, 150% or more, or 200% or more.

A structure of each of the electromagnetic shields 1a, 1b, 1c, 1d, and 1e including the plurality of first projecting portions 11 is thought to function, for example, as a diffraction grating. Regarding light diffraction, a zero-order light transmittance $I_0$ through a diffraction grating having a rectangular cross-section is expressed by the following equation (3) in accordance with a scalar diffraction theory. In the equation (3), $\varepsilon_r$ is the real part of the relative permittivity of the material forming the diffraction grating, and sqrt($\varepsilon_r$) is a square root of $\varepsilon_r$. The symbol h is a height of a protruding portion of the diffraction grating. The symbol $\lambda$ is the wavelength of light.

$$I_0 = \cos^2(\pi \cdot |\text{sqrt}(\varepsilon_r)| - 1 \cdot (h/\lambda)) \qquad \text{Equation (3)}$$

According to Bragg's law, a direction (scattering angle) of a scattered-transmitted wave generated by diffraction is determined by a pitch of protruding portions of a diffraction grating. Constructive interference and destructive interference between diffraction waves having passed through between the protruding portions generate an interference fringe. It is thought that in this case, a transmitted-scattered wave is observed as a result of constructive interference between diffraction waves. Constructive interference between diffraction waves can be expressed by an equation (4), while destructive interference between diffraction waves can be expressed by an equation (5). In the equations (4) and (5), d is a pitch of protruding portions of a diffraction grating, $\theta$ is an angle at which constructive interference or destructive interference between diffraction waves occurs, m is an integer of 0 or greater, and $\lambda$ is the wavelength of an incident wave. It is understood that when $\lambda$ is constant, the scattering angle of a transmitted-scattered wave can vary depending on the pitch of the protruding portions of the diffraction grating. Table 1 shows an example of a relation between the scattering angle θ at which constructive interference between diffraction waves occurs and the pitch d.

$$dsinθ = mλ \qquad \text{Equation (4)}$$

$$dsinθ = (m + 1/2)λ \qquad \text{Equation (5)}$$

[Table 1]

| Scattering angle θ | | Interference | Pitch d [mm] of protruding portions of diffraction grating | | | | | | | | |
|---|---|---|---|---|---|---|---|---|---|---|---|
| | | | 4 | 5 | 6 | 7 | 8 | 9 | 10 | 11 | 12 |
| Order of diffraction m | 0 | Constructive | 0° | 0° | 0° | 0° | 0° | 0° | 0° | 0° | 0° |
| | 0 | Destructive | 29° | 23° | 19° | 16° | 14° | 13° | 11° | 10° | 9° |
| | 1 | Constructive | 79° | 52° | 41° | 34° | 29° | 26° | 23° | 21° | 19° |
| | 1 | Destructive | - | - | 79° | 57° | 47° | 41° | 36° | 32° | 29° |
| | 2 | Constructive | - | - | - | - | 79° | 61° | 52° | 45° | 41° |
| | 2 | Destructive | - | - | - | - | - | - | 79° | 63° | 55° |
| | 3 | Constructive | - | - | - | - | - | - | - | - | 79° |

EXAMPLES

The present invention will be described hereinafter in more details by examples. The present invention is not limited to the examples given below. First, an evaluation method for Examples and Comparative Examples will be described.

[Transmission loss]

A radio wave having frequencies of 70 to 90 GHz was allowed to be incident on a region including an outer edge of a first surface of each of samples according to Examples and Comparative Examples to measure a transmission loss in a straight direction using a radio transceiver EAS02 manufactured by KEYCOM Corporation with reference to JIS R 1679: 2007. When the radio wave was incident in a direction perpendicular to a horizontal plane in this measurement, each sample was disposed such that an angle formed by a base of the sample with the horizontal plane was 45° or 15° and that the base extended obliquely upward toward the outer edge of the first surface of the sample. In this measurement, the measurement region had a diameter of 30 mm. The transmission loss was determined by the above equation (2). Table 2 shows the results.

<Example 1>

A plate-shaped resin molded article having one principal surface and the other, flat, principal surface, was obtained by molding using an olefin-based thermoplastic elastomer, the one principal surface including a plurality of projections projecting from a flat-plate-shaped base. A sample according to Example 1 was thus obtained. The real part ε' of a complex relative permittivity of the olefin-based thermoplastic elastomer at a frequency of 76.5 mm was 2.43, and the imaginary part ε" of the complex relative permittivity was 0.005. In the sample according to Example 1, the one principal surface including the plurality of projections was formed as the first surface, while the other principal surface was formed as the second surface. The sample according to Example 1 was disposed such that the angle formed by the base of the sample with the horizontal plane was 45° and the base extended obliquely upward toward the outer edge of the first surface of the sample. In this state, the plurality of projections was viewed from a direction opposite to a projecting direction of the plurality of projections. In this case, the plurality of projections was disposed to make a parallelogram lattice, the shape of each projection was a square 5 mm on a side, and each projection had a width of 5 mm. In this state, a distance between the projections adjacent to each other in a horizontal direction was 6.5 mm. The plurality of projections included an outer projection in the outer edge of the first surface. An outermost portion of the outer projection had a projection length of 0 mm. An innermost portion of the outer projection had a projection length of 6 mm. The innermost portion of the outer projection projected beyond the outermost portion of the outer projection, and the outer projection had a tapered shape. An inner projection, which is included in the plurality of projections but is other than the outer projection, was in the shape of a quadrangular prism, and a head of the inner projection was in the shape of a square perpendicular to the projecting direction.

An outermost portion of the inner projection had a projection length of 3.1 mm, and an innermost portion of the inner projection had a projection length of 6 mm.

<Example 2>

A sample according to Example 2 was produced in the same manner as in Example 1, except for the following points. The projection length of the outermost portion of the outer projection was adjusted to 0 mm, and the projection length of the innermost portion of the outer projection was adjusted to 3.6 mm. Moreover, a head of the outer projection was in the shape of a square perpendicular to the projecting direction.

<Example 3>

A sample according to Example 3 was produced in the same manner as in Example 1, except for the following points. In the sample according to Example 3, no outer projections were formed to make the outer edge of the first surface flat, and an auxiliary projection was formed in a place on the second surface, the place corresponding to the outer edge of the first surface. The auxiliary projection projected in the direction opposite to the projecting direction of the projection on the first surface. A distance between the outer edge of the sample and the auxiliary projection in a direction parallel to the first surface was equal to or shorter than a distance, in the direction parallel to the first surface, between the outer edge of the sample and the projection closest to the outer edge on the first surface. When the auxiliary projection is viewed along a direction opposite to a projecting direction of the auxiliary projection, the auxiliary projection was in the shape of a square 5 mm on a side. The auxiliary projection was in the shape of a quadrangular prism, and a head of the inner auxiliary projection was in the shape of a square perpendicular to the projecting direction. An outermost portion of the auxiliary projection had a projection length of 6 mm, and an innermost portion of the auxiliary projection had a projection length of 3.1 mm.

<Example 4>

A sample according to Example 4 was produced in the same manner as in Example 1, except for the following points. The sample according to Example 4 was disposed such that the angle formed by the base of the sample with the horizontal plane was 15° and the base extended obliquely upward toward the outer edge of the first surface of the sample. In this state, the plurality of projections was viewed from the direction opposite to the projecting direction of the plurality of projections. In this case, the plurality of projections was disposed to make a parallelogram lattice, the shape of each projection was a square 5 mm on a side, and each projection had a width of 5 mm. In this state, the distance between the projections adjacent to each other in the horizontal direction was 6.5 mm. The plurality of projections included the outer projection in the outer edge of the first surface. The outermost portion of the outer projection had a projection length of 0 mm. The innermost portion of the outer projection had a projection length of 5 mm. The innermost portion of the outer projection projected beyond the outermost portion of the outer projection, and the outer projection had a tapered shape. The inner projection, which is included in the plurality of projections but is other than the outer projection, was in the shape of a quadrangular prism, and the head of the inner projection was in the shape of a square perpendicular to the projecting direction. The outermost portion of the inner projection had a projection length of 3.8 mm, and the innermost portion of the inner projection had a projection length of 5 mm.

<Example 5>

A sample according to Example 5 was produced in the same manner as in Example 4, except for the following points. The projection length of the outermost portion of the outer projection was adjusted to 2 mm, and the projection length of the innermost portion of the outer projection was adjusted to 4.4 mm. Moreover, the head of the outer projection was in the shape of a square perpendicular to the projecting direction.

<Example 6>

A sample according to Example 6 was produced in the same manner as in Example 4, except for the following points. In the sample according to Example 6, no outer projections were formed to make the outer edge of the first surface flat, and the auxiliary projection was formed in a place on the second surface, the place corresponding to the outer edge of the first surface. The auxiliary projection projected in the direction opposite to the projecting direction of the projection on the first surface. The distance between the outer edge of the sample and the auxiliary projection in the direction parallel to the first surface was equal to or shorter than the distance, in the direction parallel to the first surface, between the outer edge of the sample and the projection closest to the outer edge on the first surface. When the auxiliary projection is viewed along the direction opposite to the projecting direction of the auxiliary projection, the auxiliary projection was in the shape of a square 5 mm on a side. The auxiliary projection was in the shape of a quadrangular prism, and the head of the inner auxiliary projection was in the shape of a square perpendicular to the projecting direction. The outermost portion of the auxiliary projection had a projection length of 5 mm, and the innermost portion of the auxiliary projection had a projection length of 3.8 mm.

<Example 7>

A sample according to Example 7 was produced in the same manner as in Example 1, except for the following points. On the second surface of the sample according to Example 7, the auxiliary projection was formed at a position corresponding to the outer projection on the first surface. The auxiliary projection projected in the direction opposite to the projecting direction of the projection on the first surface. The outermost portion of the auxiliary projection had a projection length of 0 mm, and the innermost portion of the auxiliary projection had a projection length of 6 mm. The innermost portion of the auxiliary projection projected beyond the outermost portion of the auxiliary projection, and the auxiliary projection had a tapered shape.

<Example 8>

A sample according to Example 8 was produced in the same manner as in Example 2, except for the following points. On the second surface of the sample according to Example 8, the auxiliary projection was formed at a position corresponding to the outer projection on the first surface. The auxiliary projection projected in the direction opposite to the projecting direction of the projection on the first surface. The outermost portion of the auxiliary projection had a projection length of 0 mm, and the innermost portion of the auxiliary projection had a projection length of 3.6 mm. Moreover, the head of the outer projection was in the shape of a square perpendicular to the projecting direction.

<Comparative Example 1>

A sample according to Comparative Example 1 was produced in the same manner as in Example 1, except that the outer projection was formed in the same shape as the inner projection.

<Comparative Example 2>

A sample according to Comparative Example 2 was produced in the same manner as in Example 4, except that the outer projection was formed in the same shape as the inner projection.

<Comparative Example 3>

A sample according to Comparative Example 3 was produced in the same manner as in Example 1, except that no outer projections were formed to make the outer edge of the first surface flat.

<Comparative Example 4>

A sample according to Comparative Example 4 was produced in the same manner as in Example 4, except that no outer projections were formed to make the outer edge of the first surface flat.

As shown in Table 2, in the samples according to Examples 1, 2, 4, 5, 7, and 8, the projection length of the outermost portion of the outer projection is shorter than the projection length of the outermost portion of the inner projection; it is understood that the outer projection is less likely to hinder attachment of these samples to other components. On the other hand, in the samples according to Comparative Examples 1 and 2, the projection length of the outermost portion of the outer projection is the same as the projection length of the outermost portion of the inner projection; it is understood that the outer projection is more likely to hinder attachment of these samples to other components.

As to the samples according to Examples 1, 2, 4, 5, 7, and 8, the transmission loss in the straight direction is 16 dB or more. This indicates that a high transmission loss is achieved owing to the outer projection. Additionally, according to Examples 7 and 8, a higher transmission loss can be achieved when the auxiliary projection is provided in addition to the outer projection.

In the samples according to Examples 3 and 6, no projection corresponding to the outer projection of the sample according to Example 1 was provided and the outer edge of the first surface was flat. This is thought to make it easy to attach the samples according to Examples 3 and 6 to other components. Moreover, the samples according to Examples 3 and 6 are thought to achieve a high transmission loss owing to the auxiliary projection thereof. On the other hand, in the samples according to Comparative Examples 3 and 4, neither outer projection nor auxiliary projection is provided, and the transmission loss in the straight direction is low.

[Table 2]

| | First surface | | | | | Second surface | | Inclination angle of base in transmission loss measurement | Transmission loss in straight direction [d6] |
|---|---|---|---|---|---|---|---|---|---|
| | Projection length of outermost portion of inner projection [mm] | With or without outer projection [mm] | Projection length of outermost portion of outer projection [mm] | Shape of head of outer projection | Angle formed between direction perpendicular to base and projecting direction of projection | With or without auxiliary projection | Shape of head of auxiliary projection | | |
| Ex. 1 | 3.1 | With | 0 | Tapered | 45° | Without | - | 30° | 19 |
| Ex. 2 | 3.1 | With | 0 | Square | 45° | Without | - | 30° | 17 |
| Ex. 3 | 3.1 | Without | - | - | 45° | With | Square | 30° | 18 |
| Ex. 4 | 3.8 | With | 0 | Tapered | 15° | Without | - | 18° | 16 |
| Ex. 5 | 3.8 | With | 2 | Square | 15° | Without | - | 18° | 17 |
| Ex. 6 | 3.8 | Without | - | - | 15° | With | Square | 18° | 16 |
| Ex. 7 | 3.1 | With | 0 | Tapered | 45° | With | Tapered | 30° | 21 |
| Ex. 8 | 3.1 | With | 0 | Square | 45° | With | Square | 30° | 19 |
| Comp. Ex. 1 | 3.1 | With | 3.1 | Square | 45° | Without | - | 30° | 20 |
| Comp. Ex. 2 | 3.8 | With | 3.8 | Square | 15° | Without | - | 18° | 16 |
| Comp. Ex. 3 | 3.1 | Without | - | - | 45° | Without | - | 30° | 8 |
| Comp. Ex. 4 | 3.8 | Without | - | - | 15° | Without | - | 18° | 8 |

**Claims**

1. An electromagnetic shield, comprising:

   a plate-shaped base having a first surface and a second surface, the first surface being configured to allow an electromagnetic wave to be incident on the first surface, the second surface being distant from the first surface and extending along the first surface;
   a plurality of first projecting portions projecting from the first surface in a direction away from the second surface; and
   a contact portion configured to be in contact with a component other than the electromagnetic shield, wherein the electromagnetic shield includes a dielectric,
   the electromagnetic shield is capable of being attached to the component such that the component is in contact with the contact portion and the first surface faces the component, and
   the electromagnetic shield satisfies at least one selected from the group consisting of the following requirements (I) and (II):

   (I) the electromagnetic shield includes, in a particular portion, a second projecting portion projecting from the second surface in a direction away from the first surface, and a distance from the contact portion to the particular portion in a direction parallel to the first surface is equal to or shorter than a first distance between the first projecting portion closest to the contact portion and the contact portion, the particular portion being a portion including the contact portion and the first projecting portion closest to the contact portion; and
   (II) the plurality of first projecting portions includes a proximal projecting portion and a distal projecting portion, a projection length of the proximal projecting portion is shorter than a projection length of the distal projecting portion, and the distal projecting portion is adjacent to the proximal projecting portion in a direction away from the contact portion.

2. The electromagnetic shield according to claim 1, wherein

   at least one of the electromagnetic shield and the base is a ring-shaped body and has a polygonal or circular outer perimeter when the first surface is viewed along an axis of the ring-shaped body, and
   the contact portion abuts on the outer perimeter.

3. The electromagnetic shield according to claim 2, wherein

   at least one of the electromagnetic shield and the base is a hollow body whose outer shape is a truncated pyramidal shape, a truncated conical shape, or a truncated elliptical conical shape and which has an opening in each of positions in the outer shape, the positions corresponding to an upper base and a lower base of a truncated pyramid, a truncated cone, or a truncated elliptic cone,
   the first surface defines an inner peripheral surface of the hollow body being the electromagnetic shield or the base, and
   the second surface defines an outer peripheral surface of the hollow body being the electromagnetic shield or the base.

4. The electromagnetic shield according to claim 3, wherein the plurality of first projecting portions projects in a direction perpendicular to the lower base.

5. The electromagnetic shield according to claim 1, wherein the electromagnetic shield is free of an electrically conductive portion.

6. The electromagnetic shield according to claim 1, wherein an imaginary part $\varepsilon''$ of a relative permittivity of the dielectric at at least one frequency in a range of 10 GHz to 300 GHz is 0.1 or less.

7. The electromagnetic shield according to claim 1, wherein a real part $\varepsilon'$ of a relative permittivity of the dielectric at at least one frequency in a range of 10 GHz to 300 GHz is 2.0 to 4.0.

8. The electromagnetic shield according to claim 1, wherein

   the electromagnetic shield is capable of shielding against an electromagnetic wave with a wavelength $\lambda$, and

at least one of projection lengths pi of the first projecting portions satisfies a requirement $0.25\lambda \leq p_i \leq 1.3\lambda$.

9. The electromagnetic shield according to claim 1, wherein

the electromagnetic shield is capable of shielding against an electromagnetic wave with a wavelength $\lambda$, and at least one of widths $w_i$ of the first projecting portions satisfies a requirement $0.51\lambda \leq w_i \leq 1.6\lambda$.

10. The electromagnetic shield according to claim 1, wherein

the electromagnetic shield is capable of shielding against an electromagnetic wave with a wavelength $\lambda$, and an interval $i_i$ between the first projecting portions adjacent to each other satisfies a requirement $0.51 \lambda \leq i_i \leq 1.6\lambda$.

11. The electromagnetic shield according to claim 1, wherein the first projecting portion has a shape of at least one selected from the group consisting of a circle, a triangle, a quadrilateral, and a polygon having five or more corners when viewed in plan.

12. The electromagnetic shield according to claim 1, wherein arrangement of the plurality of first projecting portions is at least one selected from the group consisting of arrangement at lattice points, arrangement on parallel lines, and random arrangement in plan view.

FIG. 1

FIG.2

FIG.3

FIG.4

FIG.5

FIG.6

FIG. 7A

FIG.7B

FIG.7C

FIG.8

**FIG.9**

**FIG.10**

FIG.11

## INTERNATIONAL SEARCH REPORT

| International application No. |
| --- |
| **PCT/JP2022/028279** |

**A. CLASSIFICATION OF SUBJECT MATTER**

*G01S 7/03*(2006.01)i; *H05K 9/00*(2006.01)i; *G01S 13/931*(2020.01)n
FI: G01S7/03 220; H05K9/00 M; G01S13/931

According to International Patent Classification (IPC) or to both national classification and IPC

**B. FIELDS SEARCHED**

Minimum documentation searched (classification system followed by classification symbols)

G01S7/00-G01S7/42; G01S13/00-G01S13/95; H05K9/00; H01Q1/00-H01Q1/52

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 11-40689 A (SUMITOMO ELECTRIC INDUSTRIES, LTD.) 12 February 1999 (1999-02-12) paragraphs [0011]-[0031], fig. 3-9 | 1, 11-12 |
| Y | paragraphs [0011]-[0031], fig. 3-9 | 2-10 |
| Y | JP 2014-134414 A (MAZDA MOTOR CORP) 24 July 2014 (2014-07-24) paragraphs [0035]-[0080], fig. 4-11 | 2-10 |
| Y | US 2016/0268693 A1 (AUTOLIV ASP INC.) 15 September 2016 (2016-09-15) paragraphs [0054]-[0078], fig. 1-11 | 2-10 |
| A | JP 2004-138415 A (HITACHI LTD) 13 May 2004 (2004-05-13) entire text, all drawings | 1-12 |
| A | JP 2005-94537 A (TDK CORP) 07 April 2005 (2005-04-07) entire text, all drawings | 1-12 |

☐ Further documents are listed in the continuation of Box C.  ☑ See patent family annex.

| | |
| --- | --- |
| * Special categories of cited documents: <br> "A" document defining the general state of the art which is not considered to be of particular relevance <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
| --- | --- |
| **07 September 2022** | **20 September 2022** |

| Name and mailing address of the ISA/JP | Authorized officer |
| --- | --- |
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (January 2015)

**INTERNATIONAL SEARCH REPORT**
Information on patent family members

International application No.

**PCT/JP2022/028279**

| Patent document cited in search report | | | Publication date (day/month/year) | Patent family member(s) | | | Publication date (day/month/year) |
|---|---|---|---|---|---|---|---|
| JP | 11-40689 | A | 12 February 1999 | US 6163072 A column 4, line 58 to column 15, line 37, fig. 3-9 | | | |
| JP | 2014-134414 | A | 24 July 2014 | (Family: none) | | | |
| US | 2016/0268693 | A1 | 15 September 2016 | WO 2016/144956 A1 EP 3268767 A1 | | | |
| JP | 2004-138415 | A | 13 May 2004 | US 2004/0135720 A1 entire text, all drawings EP 1411583 A1 | | | |
| JP | 2005-94537 | A | 07 April 2005 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5696781 B

- US 10074907 B2